# EUROPEAN PATENT SPECIFICATION

(11) **EP 4 403 944 B1**
(45) Date of publication and mention of the grant of the patent: **09.12.2026**
(21) Application number: 23737418.6
(22) Date of filing: 05.01.2023
(51) Int. Cl.: G01R 31/389, G01R 27/02, G01R 27/08, G01R 31/3835, G01R 15/04, G01R 31/385, G01R 31/396

(54) **BATTERY APPARATUS AND BATTERY MANAGEMENT SYSTEM FOR MEASURING INSULATION RESISTANCE**
BATTERIEVORRICHTUNG UND BATTERIEVERWALTUNGSSYSTEM ZUR ISOLATIONSWIDERSTANDSMESSUNG
DISPOSITIF DE BATTERIE ET SYSTÈME DE GESTION DE BATTERIE POUR LA MESURE DE RÉSISTANCE D'ISOLATION

(30) Priority: 06.01.2022 KR 20220002135
(43) Date of publication of application: 24.07.2024
(73) Proprietor: LG Energy Solution, Ltd., Seoul 07335 (KR)
(72) Inventor: CHOI, Jang Hyeok, Daejeon 34122 (KR); KIM, Tae Youn, Daejeon 34122 (KR); KIM, Minwoo, Daejeon 34122 (KR); PARK, Yeondo, Daejeon 34122 (KR)
(74) Representative: Goddar, Heinz J.
(86) International application number: PCT/KR2023/000250
(87) International publication number: WO 2023/132670

(56) References cited:
- EP-B1- 2 796 887
- KR-A- 20130 109 066
- KR-A- 20200 109 925
- KR-A- 20210 060 210
- KR-A- 20210 073 049
- KR-A- 20210 073 049
- KR-B1- 102 099 414
- US-A1- 2019 047 436
- US-A1- 2020 116 791
- US-A1- 2020 217 893
- US-A1- 2021 318 372

## Description

### [Technical Field]

### Cross-reference to related application(s)

This application claims priority to and the benefit of Korean Patent Application No. 10-2022-0002135 filed in the Korean Intellectual Property Office on January 6, 2022.

The present invention relates to a battery unit and a battery management system for measuring insulation resistance.

### [Background Art]

Electric vehicles and hybrid vehicles are vehicles obtaining power by mainly using batteries as power sources for driving motors, and are alternatives capable of solving pollution and energy problems of internal combustion vehicles. For this reason, research has been actively carried out on them. Further, rechargeable batteries have been used in electric vehicles and even in various other external apparatuses.

As high-power high-capacity batteries have been required, battery packs including a plurality of battery cells connected, and battery management systems for managing battery packs have been used. It is important for units using such battery packs to maintain an insulated state. In the case where the insulated state of a battery pack is not maintained, leakage current may occur, resulting in various problems. For this reason, battery management systems use circuits for measuring the insulation resistance of a battery pack in order to prevent leakage current from occurring.

Meanwhile, since battery management systems need circuits for monitoring the high voltage of battery packs as well, the costs of battery management systems may increase due to insulation resistance measurement circuits and high-voltage monitoring circuits.

US 20202 217893 A1 describes an apparatus and method for diagnosing a short circuit accident occurring at a positive electrode contactor of a battery pack. This apparatus diagnoses a positive electrode contactor of a battery pack, which includes a positive electrode contactor provided on a charge-discharge path connected to a positive electrode terminal and a negative electrode contactor provided on a charge-discharge path connected to a negative electrode terminal.

### [Disclosure]

### [Technical Problem]

The present invention has been made in an effort to provide a battery unit and a battery management system capable of being integrated with an insulation resistance measurement circuit and a high-voltage monitoring circuit.

### [Technical Solution]

The present invention is defined according to the subject matter of the appended independent claims. Particular embodiments are given by the additional features of the appended dependent claims.

According to the invention, it is possible to reduce the cost of a battery management system by integrating an insulation resistance measurement circuit and a high-voltage monitoring circuit with it.

### [Description of the Drawings]

FIG. 1 is a drawing illustrating an example of a battery unit according to an example embodiment of the present invention.
FIG. 2 is a drawing illustrating an example of a battery unit according to another example embodiment of the present invention.
FIG. 3 is a drawing for explaining measurement of the voltage of a battery pack in the battery unit shown in FIG. 2.
FIG. 4 and FIG. 5 each are a drawing for explaining measurement of insulation resistance in the battery unit shown in FIG. 2.
FIG. 6 is a drawing illustrating an example of a battery unit according to another example embodiment of the present invention.
FIG. 7 is a drawing illustrating an example of a battery unit according to another example embodiment of the present invention.

### [Mode for Invention]

In the following detailed description, only certain example embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. Like reference numerals designate like elements throughout the specification.

It should be understood that when a constituent element is referred to as being "connected" to another constituent element, it may be directly connected to the other constituent element, or other constituent elements may be present between them. In contrast, it should be understood that when a constituent element is referred to as being "directly connected" to another constituent element, there is no other constituent element between them.

In the following description, expressions written in the singular forms can be comprehended as the singular forms or plural forms unless clear expressions such as "a", "an", or "single" are used.

In the flow charts described with reference to the drawings, the order of operations may be changed, and several operations may be combined, and an operation may be divided, and some operations may not be performed.

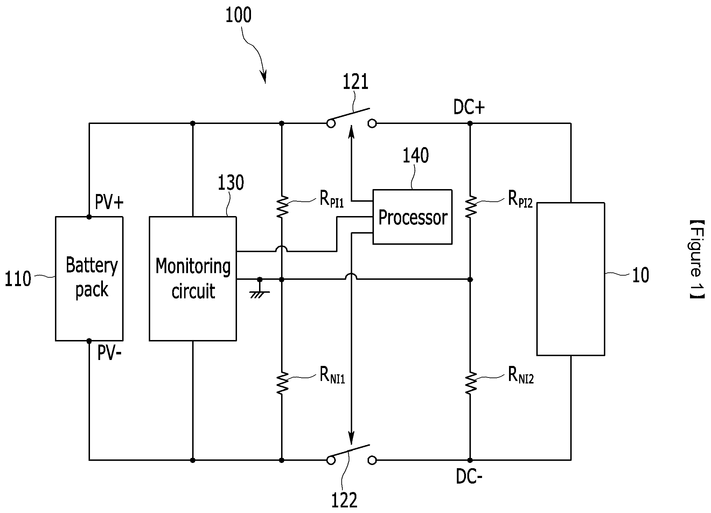

FIG. 1 is a drawing illustrating an example of a battery unit according to an example embodiment of the present invention.

Referring to FIG. 1, a battery unit 100 has a structure electrically connectable to an external device through its positive link terminal DC+ and its negative link terminal DC-. In the case where the external device is a load, the battery unit 100 may serve as a power source for supplying power to the load, thereby being discharged. In the case where the external device is a charger, the battery unit 100 may receive external power through the charger, thereby being charged. In some example embodiments, the external device serving as a load may be, for example, an electronic apparatus, a transportation means, or an energy storage system (ESS), and the transportation means may be a vehicle such as an electric vehicle, a hybrid vehicle, or smart mobility. In some example embodiments, in the case of a vehicle, the positive link terminal DC+ and the negative link terminal DC- of the battery unit 100 may be connected to inverters (not shown in the drawings), and the battery unit 100 may be connected to the motor of the vehicle serving as a load, through the inverters.

The battery unit 100 includes a battery pack 110, main switches 121 and 122, a monitoring circuit 130, and a processor 140.

The battery pack 110 has a positive terminal PV+ and a negative terminal PV-. The battery pack 110 may include a plurality of battery cells which is connected in series between the positive terminal PV+ and the negative terminal PV-. In some example embodiments, the negative terminal PV- of the battery pack 110 may be connected to a ground terminal of the battery unit. In some example embodiments, the battery pack 110 may include a plurality of battery modules connected in series between the positive terminal PV+ and the negative terminal PV-, and each battery module may include a plurality of battery cells which is connected in series. In some example embodiments, the battery cells may be secondary batteries which are rechargeable.

The main switches 121 and 122 include an anodic main switch 121 that is connected between the positive terminal PV+ of the battery pack 110 and the positive link terminal DC+ of the battery unit 100, and a cathodic main switch 122 that is connected between the negative terminal PV- of the battery pack 110 and the negative connection link terminal DC- of the battery unit 100. The main switches 121 and 122 may electrically connect the battery pack 110 and the external device 10 under control of the processor 140. In some example embodiments, each of the main switches 121 and 122 may include a contactor including a relay. In some example embodiments, each of the main switches 121 and 122 may include an electric switch such as a transistor. In some example embodiments, the battery unit 100 may further include driver circuits (not shown in the drawings) for driving the main switches 121 and 122 in response to control signals from the processor 140, respectively. When the anodic main switch 121 and the cathodic main switch 122 are closed, power can be supplied from the battery pack 110 to the external device, or power can be supplied from the external device to the battery pack 110. Closing a switch may be referred to as turning on the switch, and opening a switch may be referred to as turning off the switch.

Between the positive terminal PV+ of the battery pack 110 and the ground terminal of the external device 10, insulation resistance R_{PI1} of the battery unit 100 is formed, and between the negative terminal PV- of the battery pack 110 and the ground terminal of the external device 10, insulation resistance R_{NI1} of the battery unit 100 is formed. Further, between the positive link terminal DC+ of the battery pack 110 and the ground terminal of the external device 10, insulation resistance R_{PI2} of the external device 10 is formed, and between the negative link terminal DC- of the battery pack 110 and the ground terminal of the external device 10, insulation resistance R_{NI2} of the external device 10 is formed. The ground terminal of the external device 10 may be, for example, the chassis of a vehicle.

The monitoring circuit 130 is connected to the positive terminal PV+ and the negative terminal PV- of the battery pack 110 and the ground terminal of the external device 10, and monitors the voltage of the battery pack 110 and insulation resistance R_{PI1}, R_{PI2}, R_{NI1}, and R_{PI2}.

The processor 140 controls the monitoring circuit 130, and measures the voltage and insulation resistance R_{PI1}, R_{PI2}, R_{NI1}, and R_{NI2} of the battery pack 110 on the basis of information from the monitoring circuit 130. Further, the processor 140 controls the operations of the main switches 121 and 122. In some example embodiments, the processor 140 may be, for example, a micro controller unit (MCU).

In some example embodiments, the monitoring circuit 130 and the processor 140 may form a battery management system.

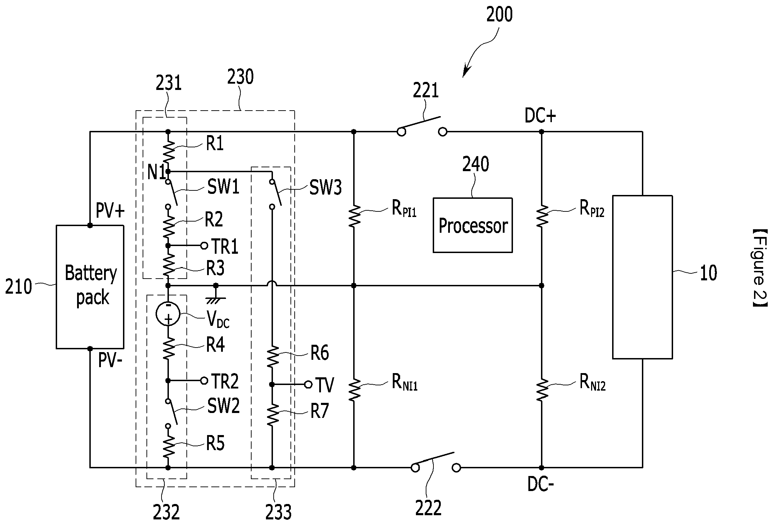

Now, monitoring circuits according to various example embodiments will be described with reference to FIG. 2 to FIG. 9.

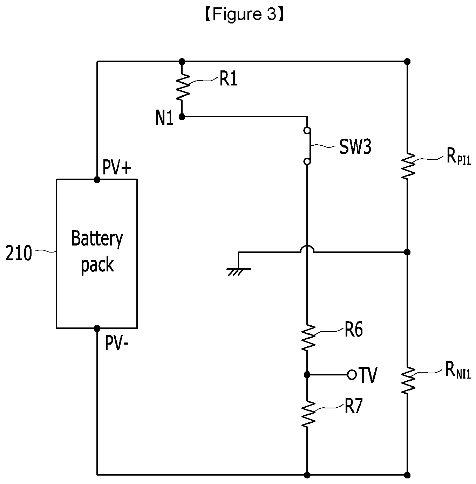

FIG. 2 is a drawing illustrating an example of a battery unit according to another example embodiment of the present invention, and FIG. 3 is a drawing for explaining measurement of the voltage of a battery pack in the battery unit shown in FIG. 2, and FIG. 4 and FIG. 5 each are a drawing for explaining measurement of insulation resistance in the battery unit shown in FIG. 2.

Referring to FIG. 2, a battery unit 200 includes a battery pack 210, main switches 221 and 222, a monitoring circuit 230, and a processor 240. The battery pack 210, the main switches 221 and 222, and the processor 240 are similar to the battery pack 110, the main switches 121 and 122, and the processor 140 described with reference to FIG. 1, so a description thereof will not be made.

The monitoring circuit 230 includes a first insulation resistance monitoring circuit 231, a second insulation resistance monitoring circuit 232, and a voltage monitoring circuit 233.

The first insulation resistance monitoring circuit 231 includes a resistor (or a first resistor) R1 that is connected between the positive terminal PV+ of the battery pack 210 and a node N1, and a switch (or a first switch) SW1 and resistors (or second and sixth resistors, or second and third resistors) R2 and R3 that are connected in series between the node N1 and the ground terminal of the external device, and has a first insulation resistance monitoring terminal (or a first monitoring terminal) TR1 on a path which is formed by the resistors R2 and R3 and the switch SW1. The first insulation resistance monitoring terminal TR1 may be connected to one terminal of the resistor R2 or one terminal of the resistor R3. In some example embodiments, a first terminal of the switch SW1 may be connected to the node N1, and the resistor R2 may be connected between a second terminal of the switch SW2 and the monitoring terminal TR1, and the resistor R3 may be connected between the monitoring terminal TR1 and the ground terminal.

In some example embodiments, the order of connection of the switch SW1 and the resistors R2 and R3 between the node N1 and the ground terminal may be changed. In this case, a node through which a voltage that is obtained by voltage division using the resistors R2 and R3 can be output (for example, the contact point of the resistors R2 and R3) may be set as the monitoring terminal TR1.

The second insulation resistance monitoring circuit 232 includes resistors (or third and fourth resistors, or fourth and fifth resistors) R4 and R5 that are connected in series between the ground terminal of the external device and the negative terminal PV- of the battery pack 210, and a switch (or a second switch) SW2, and has a second insulation resistance monitoring terminal (or a second monitoring terminal) TR2 on a path which is formed by the resistors R4 and R5 and the switch SW2. The second insulation resistance monitoring terminal TR2 may be connected to one terminal of the resistor R4 or one terminal of the resistor R5. In some example embodiments, the resistor R4 may be connected between the ground terminal and the monitoring terminal TR2, and a first terminal of the switch SW2 may be connected to the monitoring terminal TR2, and the resistor R5 may be connected between a second terminal of the switch SW2 and the negative terminal PV- of the battery pack 210.

In some example embodiments, the second insulation resistance monitoring circuit 232 may further include a DC voltage source V_{DC} on a path which is formed by the resistors R4 and R5 and the switch SW2. Since the resistors R4 and R5 are connected between the negative terminal PV- of the battery pack 210 and the ground terminal, the DC voltage source V_{DC} may be provided such that the voltage of the second insulation resistance monitoring terminal TR2 can become a positive voltage. In some example embodiments, the anode of the DC voltage source V_{DC} may be connected to the ground terminal, and the cathode of the DC voltage source V_{DC} may be connected to one terminal of the resistor R4.

In some example embodiments, the order of connection of the DC voltage source V_{DC}, the resistors R4 and R5, and the switch SW2 between the ground terminal and the negative terminal PV- of the battery pack 210 may be changed. In this case, a node through which a voltage that is obtained by voltage division using the resistors R4 and R5 can be output (for example, the contact point of the resistors R4 and R5) may be set as the monitoring terminal TR2.

The voltage monitoring circuit 233 includes a switch (or a third switch) SW3 and resistors (or fifth and seventh resistors, or sixth and seventh resistors) R6 and R7 that are connected in series between one node N1 in the first insulation resistance monitoring circuit 231 and the negative terminal PV- of the battery pack 210, and has a voltage monitoring terminal (or a third monitoring terminal) TV on a path which is formed by the switch SW3 and the resistors R6 and R7. The voltage monitoring terminal TV may be connected to one terminal of the resistor R6 or one terminal of the resistor R7. In some example embodiments, a first terminal of the switch SW3 may be connected to the node N1 of the first insulation resistance monitoring circuit 231, and the resistor R6 may be connected between a second terminal of the switch SW3 and the voltage monitoring terminal TV, and the resistor R7 may be connected between the voltage monitoring terminal TV and the negative terminal PV- of the battery pack 210.

In some example embodiments, the order of connection of the switch SW3 and the resistors R6 and R7 between the node N1 and the negative terminal PV- of the battery pack 210 may be changed. In this case, a node through which a voltage that is obtained by voltage division using the resistors R6 and R7 can be output (for example, the contact point of the resistors R6 and R7) may be set as the monitoring terminal TV.

The processor 240 may control the operations of the switches SW1, SW2, and SW3, and measure the voltage of the battery pack 210 on the basis of the voltage of the voltage monitoring terminal TV, and measure the insulation resistance R_{PI1} and R_{PI2} on the basis of the voltage of the battery pack 210, the voltage of the first insulation resistance monitoring terminal TR1, and the voltage of the second insulation resistance monitoring terminal TR2.

In some example embodiments, the battery unit 200 may further include an analog-to-digital converter that converts the voltage of the first insulation resistance monitoring terminal TR1 into a digital signal and transmits the digital signal to the processor 240, an analog-to-digital converter that converts the voltage of the second insulation resistance monitoring terminal TR2 into a digital signal and transmits the digital signal to the processor 240, and an analog-to-digital converter that converts the voltage of the voltage monitoring terminal TV into a digital signal and transmits the digital signal to the processor 240.

Now, a method of measuring the insulation resistance and the battery pack voltage in the battery unit shown in FIG. 2 will be described.

First, battery pack voltage measurement will be described with reference to FIG. 3.

The processor 240 turns on the switch SW3 in the state where the switches SW1 and SW2 are off. Then, a current path passing through the resistors R1, R6, and R7 may be formed between the positive terminal PV+ of the battery pack 210 and the negative terminal PV- of the battery pack 210, as shown in FIG. 3. However, since the switches SW1 and SW2 are off, any current path is not formed between the node N1 and the ground terminal of the external device and between the ground terminal and the negative terminal PV-of the battery pack 210. Therefore, the voltage V_{PACK} of the battery pack 210 can be divided by the resistors R1, R6, and R7 as shown in Equation 1, whereby the fraction thereof can be output as the voltage V_{P} of the voltage monitoring terminal TV. The processor 240 may measure the voltage V_{PACK} of the battery pack 210 on the basis of the voltage V_{P} of the voltage monitoring terminal TV. ${V}_{P} = \frac{{R}_{7}}{{R}_{1} + {R}_{6} + {R}_{7}} {V}_{PACK}$ (Equation 1)

In Equation 1, R₁, R₆, and R₇ are the resistance values of the resistors R1, R6, and R7, respectively.

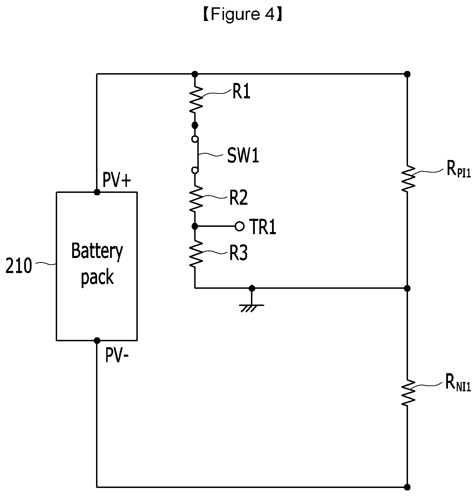

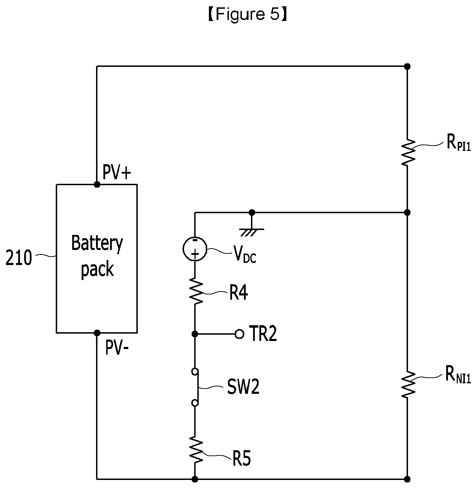

Now, insulation resistance measurement will be described with reference to FIG. 4 and FIG. 5.

Referring to FIG. 4, the processor 240 turns on the switch SW1 in the state where the switch SW2 is off and the switch SW3 is on. In some example embodiments, the processor 240 may turn off the switch SW3. By turning on the switch SW1, a current path passing through the resistors R1, R2, and R3 is formed between the positive terminal PV+ of the battery pack 210 and the ground terminal of the external device. However, since the switch SW2 is off, any current path passing through the resistors R4 and R5 is not formed. In this case, between the positive terminal PV+ of the battery pack 210 and the ground terminal of the external device, the insulation resistance R_{PI1} is formed. Therefore, between the positive terminal PV+ of the battery pack 210 and the ground terminal of the external device, a circuit in which the set of resistors R1, R2, and R3 and the insulation resistance R_{PI1} are connected in parallel is formed. Further, between the ground terminal and the negative terminal PV- of the battery pack 210, a circuit in which the insulation resistance R_{NI1} is connected is formed. In this state, the processor 240 receives the voltage V₁ of the first insulation resistance monitoring terminal TR1. The relationship between the voltage V_{PACK} of the battery pack 210 and the voltage V₁ of the first insulation resistance monitoring terminal TR1 in the circuit shown in FIG. 4 may be determined as shown in Equation 2. In the case where the switch SW3 is turned on, a current path passing through the resistors R6 and R7 is formed; however, for ease of explanation, it is assumed that the resistance values of the resistors R6 and R7 are so large that the current flowing through the resistors R6 and R7 can be ignored in Equation 2. ${V}_{PACK} = \frac{{V}_{1}}{{R}_{3}} \left({R}_{1}+{R}_{2}\right) + {V}_{1} + \left(\frac{{V}_{1}}{{R}_{3}}+\frac{\frac{{V}_{1}}{{R}_{3}} \left({R}_{1}+{R}_{2}\right) + {V}_{1}}{{R}_{PI 1}}\right) {R}_{NI 1}$ (Equation 2)

In Equation 2, R₁, R₂, R₃, R_{PI1}, and R_{NI1} are the resistance values of the resistors R₁, R₂, and R₃ and the resistance values of the resistance R_{PI1} and R_{NI1}, respectively.

Referring to FIG. 5, the processor 240 turns on the switch SW2 in the state where the switch SW1 is off and the switch SW3 is on. In some example embodiments, the processor 240 may turn off the switch SW3. By turning on the switch SW2, a current path passing through the voltage source V_{DC} and the resistors R4 and R5 is formed between the ground terminal of the external device and the negative terminal PV- of the battery pack 210. However, since the switch SW1 is off, any current path passing through the resistors R1, R2, and R3 is not formed. In this case, the insulation resistance R_{NI1} is formed between the ground terminal and the negative terminal PV- of the battery pack 210. Therefore, between the ground terminal and the negative terminal PV- of the battery pack 210, a circuit in which the set of resistors R4 and R5 and the insulation resistance R_{NI1} are connected in parallel is formed. Further, between the positive terminal PV+ of the battery pack 210 and the ground terminal of the external device, a circuit in which the insulation resistance R_{PI1} is connected is formed. In this state, the processor 240 receives the voltage V₂ of the second insulation resistance monitoring terminal TR2. The relationship between the voltage V_{PACK} of the battery pack 210 and the voltage V₂ of the second insulation resistance monitoring terminal TR2 in the circuit shown in FIG. 5 may be determined as shown in Equation 3. In the case where the switch SW3 is turned on, a current path passing through the resistors R6 and R7 is formed; however, for ease of explanation, it is assumed that the resistance values of the resistors R6 and R7 are so large that the current flowing through the resistors R6 and R7 can be ignored in Equation 3. ${V}_{PACK} = \frac{{V}_{DC} - {V}_{2}}{{R}_{4}} {R}_{5} - {V}_{2} + \left(\frac{{V}_{DC} - {V}_{2}}{{R}_{4}}+\frac{\frac{{V}_{DC} - {V}_{2}}{{R}_{4}} {R}_{5} - {V}_{2}}{{R}_{NI 1}}\right) {R}_{PI 1}$ (Equation 3)

In Equation 3, R₄, R₅, R_{PI1}, and R_{NI1} are the resistance values of the resistors R₄ and R₅ and the resistance values of the resistance R_{PI1} and R_{NI1}, respectively.

The processor 240 calculates the resistance values of the insulation resistance R_{PI1} and R_{NI1} on the basis of the voltage V₁ of the first insulation resistance monitoring terminal TR1, the voltage V₂ of the second insulation resistance monitoring terminal TR2, and the voltage V_{PACK} of the battery pack 210. The processor 240 may calculate the resistance values of the insulation resistance R_{PI1} and R_{NI1} on the basis of Equations 2 and 3 as shown in Equations 4 and 5. ${R}_{PI 1} = \frac{\left({V}_{PACK}-A\right) \left({V}_{PACK}-C\right) - AC}{D \left({V}_{PACK}-A\right) + BC}$ (Equation 4) ${R}_{NI 1} = \frac{\left({V}_{PACK}-A\right) \left({V}_{PACK}-C\right) - AC}{B \left({V}_{PACK}-A\right) + AD}$ (Equation 5)

In Equations 4 and 5, A, B, C, and D can be defined as shown in Equations 6, 7, 8, and 9, respectively. $A = \frac{{V}_{1}}{{R}_{3}} \left({R}_{1}+{R}_{2}\right) + {V}_{1}$ (Equation 6) $B = \frac{{V}_{1}}{{R}_{3}}$ (Equation 7) $C = \frac{{V}_{DC} - {V}_{2}}{{R}_{4}} {R}_{5} - {V}_{2}$ (Equation 8) $D = \frac{{V}_{DC} - {V}_{2}}{{R}_{4}}$ (Equation 9)

Meanwhile, in the case where the main switches 221 and 222 are turned on, in the circuits shown in FIG. 4 and FIG. 5, the insulation resistance R_{PI2} of the external device is connected in parallel with the insulation resistance R_{PI1} of the battery unit, and the insulation resistance R_{NI2} of the external device is connected in parallel with the insulation resistance R_{NI1} of the battery unit. Therefore, the processor 240 may calculate the resistance values of the insulation resistance R_{PI1} and R_{PI2} connected in parallel through the process described with reference to Equations 2 to 9 and the resistance values of the insulation resistance R_{NI1} and R_{NI2} connected in parallel. The processor 240 may calculate the resistance values of the insulation resistance R_{PI2} and R_{NI2} of the external device on the basis of the resistance values of the insulation resistance R_{PI1} and R_{NI1} measured when the main switches 221 and 222 were off and the resistance values of the insulation resistance R_{PI1}//R_{PI2} and R_{NI1}//R_{NI2} measured when the main switches 221 and 222 were on.

According to the example embodiments described above, the insulation resistance monitoring circuits 231 and 232 and the voltage monitoring circuit 233 may share the resistor R1, whereby it is possible to reduce the cost of the battery management system as compared to the case where the insulation resistance monitoring circuits 231 and 232 and the voltage monitoring circuit 233 may have separate resistors connected to the positive terminal PV+ of the battery pack 210.

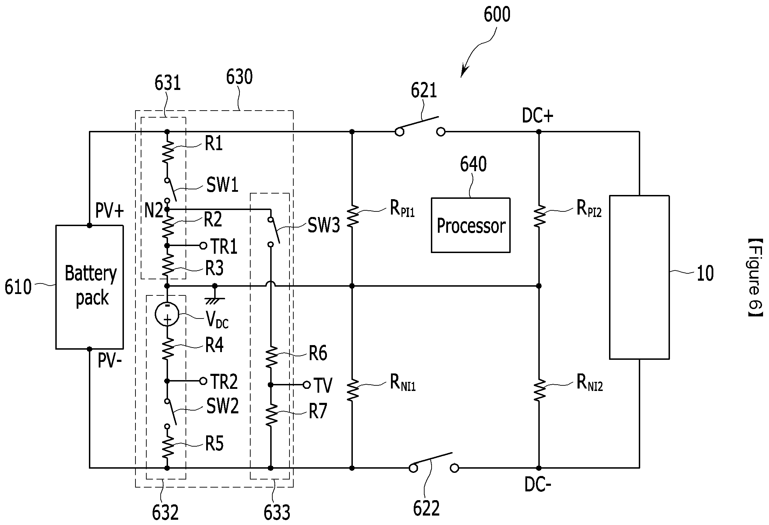

FIG. 6 is a drawing illustrating an example of a battery unit according to another example embodiment.

Referring to FIG. 6, a battery unit 600 includes a battery pack 610, main switches 621 and 622, a monitoring circuit 630, and a processor 640. The battery pack 610, the main switches 621 and 622, and the processor 640 are similar to the battery pack 110, the main switches 121 and 122, and the processor 140 described with reference to FIG. 1, so a description thereof will not be made. The monitoring circuit 630 includes a first insulation resistance monitoring circuit 631, a second insulation resistance monitoring circuit 632, and a voltage monitoring circuit 633. The monitoring circuit 630 is similar to the monitoring circuit 230 described with reference to FIG. 2, and the differences between them will be described.

A node N2 in the first insulation resistance monitoring circuit 631 to which the voltage monitoring circuit 633 is connected may be the contact point of the switch SW1 and the resistor R2. In other words, in the voltage monitoring circuit 633, the switch SW3 may be connected to the second terminal N2 of the switch SW1 of the first insulation resistance monitoring circuit 231. In some example embodiments, the first terminal of the switch SW3 may be connected to the second terminal N2 of the switch SW1, and the resistor R6 may be connected between the second terminal of the switch SW3 and the voltage monitoring terminal TV.

In this case, in order to measure the voltage of the battery pack 610, the processor 640 turns on the switches SW1 and SW3 when the switch SW2 is off. By turning on the switches SW1 and SW3, a current path passing through the resistors R1, R2, and R3 is formed between the positive terminal PV+ of the battery pack 610 and the ground terminal of the external device. In order to measure the insulation resistance R_{PI1}, R_{NI1}, R_{PI2}, and R_{NI2}, the processor 640 performs the same operation as that of the processor 240 shown in FIG. 2.

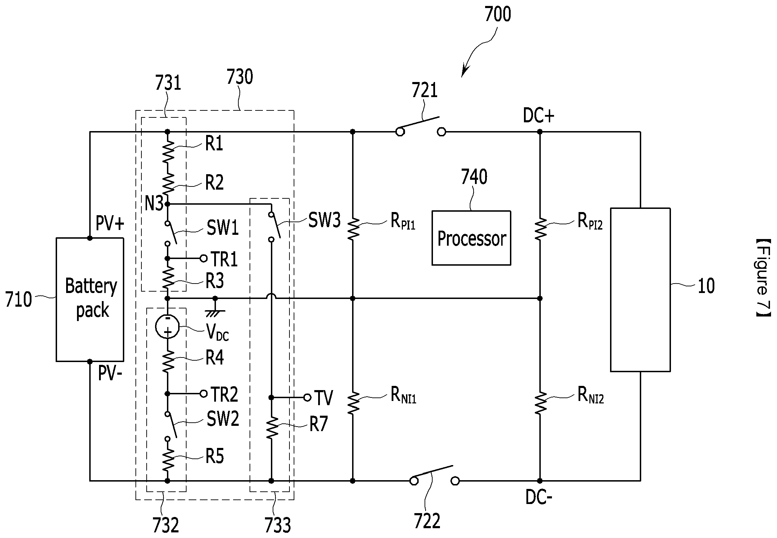

FIG. 7 is a drawing illustrating an example of a battery unit according to another example embodiment of the present invention.

Referring to FIG. 7, a battery unit 700 includes a battery pack 710, main switches 721 and 722, a monitoring circuit 730, and a processor 740. The battery pack 710, the main switches 721 and 722, and the processor 740 are similar to the battery pack 110, the main switches 121 and 122, and the processor 140 described with reference to FIG. 1, so a description thereof will not be made. The monitoring circuit 730 includes a first insulation resistance monitoring circuit 731, a second insulation resistance monitoring circuit 732, and a voltage monitoring circuit 733. The monitoring circuit 730 is similar to the monitoring circuit 230 described with reference to FIG. 2, and the differences between them will be described.

In the first insulation resistance monitoring circuit 731, the switch SW1 may be connected between the resistor R2 and the resistor (or the second resistor) R3, and a node N3 in the first insulation resistance monitoring circuit 731 to which the voltage monitoring circuit 733 is connected may be the contact point of the resistor R2 and the switch SW1. In some example embodiments, the resistor R2 may be connected between one terminal of the resistor R1 and the node N3, and the switch SW1 may be connected between the node N3 and the first insulation resistance monitoring terminal TR1, and the resistor R3 may be connected between the first insulation resistance monitoring terminal TR1 and the ground terminal of the external device. The switch SW3 in the voltage monitoring circuit 733 may be connected to the node N3. In some example embodiments, the voltage monitoring circuit 733 may not include the resistor R6, and the switch SW3 may be connected between the node N3 and the voltage monitoring terminal TV. In some example embodiments, the resistors R1 and R2 of the first insulation resistance monitoring circuit 731 may be replaced with one resistor.

In this case, in order to measure the voltage of the battery pack 710 and the insulation resistance, the processor 740 performs the same operation as that of the processor 240 shown in FIG. 2.
In some example embodiments, the switch SW3 of the voltage monitoring circuit 233, 633, or 733 may be removed from the circuits shown in FIG. 2, FIG. 6, and FIG. 7, whereby it is possible to further reduce the cost of the battery management system. In some example embodiments, a resistor having a large resistance value may be used in the voltage monitoring circuit 233, 633, or 733. If the switch SW3 is removed, leakage current through a resistor of the voltage monitoring circuit 233, 633, or 733 may occur; however, when a resistor having a large resistance value is used, leakage current can be ignored.

## Claims

1. A battery unit (100; 200; 600; 700) which is connectable to an external device (10), comprising:
a battery pack (110; 210; 610; 710);
a first resistor (R1) connected between a positive terminal (PV+) of the battery pack (110; 210; 610; 710) and a node (N1; N2; N3);
a second resistor (R3) arranged to be connected between the node (N1; N2; N3) and a ground terminal of the external device (10) when the battery unit (100; 200; 600; 700) is connected to the external device (10);
a third resistor (R4) and a fourth resistor (R5) arranged to be connected between the ground terminal and a negative terminal (PV-) of the battery pack (110; 210; 610; 710) when the battery unit (100; 200; 600; 700) is connected to the external device (10);
a fifth resistor (R7) connected between the node (N1; N2; N3) and the negative terminal (PV-) of the battery pack (110; 210; 610; 710); and
a processor (140; 240; 640; 740) configured to measure a voltage of the battery pack (110; 210; 610; 710) based on a voltage of a first terminal of the fifth resistor (R6, R7), and measure a first insulation resistance (R_{PI1}) formed between the positive terminal (PV+) of the battery pack (110; 210; 610; 710) and the ground terminal and a second insulation resistance (R_{PI2}) formed between the negative terminal (PV-) of the battery pack (110; 210; 610; 710) and the ground terminal based on a voltage of a first terminal of the second resistor (R2, R3) and a voltage of a contact point of the third resistor (R4) and the fourth resistor (R5),
wherein the battery unit (100; 200; 600; 700) further comprises:
a first switch (SW1) and a sixth resistor (R2) arranged to be connected between the node (N1) and the ground terminal on a path where the second resistor (R3) is positioned;
a second switch (SW2) arranged to be connected between the ground terminal and the negative terminal (PV-) of the battery pack (110; 210; 610; 710) on a path where the third resistor (R4) and the fourth resistor (R5) are positioned; and
a seventh resistor (R6) connected between the node (N1) and the negative terminal (PV-) of the battery pack (110; 210; 610; 710) on a path where the fifth resistor (R7) is positioned.

2. The battery unit (100; 200; 600; 700) of claim 1, further comprising:
a DC voltage source (V_{DC}) arranged to be connected between the ground terminal and the negative terminal (PV-) of the battery pack (110; 210; 610; 710) on a path where the third resistor (R4) and the fourth resistor (R5) are positioned.

3. The battery unit (100; 200; 600; 700) of claim 1, further comprising:
a third switch (SW3) connected between the node (N1) and the negative terminal (PV-) of the battery pack (110; 210; 610; 710) on a path where the fifth resistor (R7) and the seventh resistor (R6) are positioned.

4. The battery unit (100; 200; 600; 700) of claim 1, wherein:
the processor (140; 240; 640; 740) is configured to perform the following:
measuring the voltage of the battery pack (110; 210; 610; 710) based on a voltage computed by dividing the voltage using resistances of the fifth resistor (R7) and the seventh resistor (R6), when the first switch (SW1) and the second switch (SW2) are off; and
measuring the first insulation resistance (R_{PI1}) and the second insulation resistance (R_{PI2}) based on the voltage of the battery pack (110; 210; 610; 710), a voltage computed by dividing the voltage using resistances of the second resistor and the sixth resistor when the first switch (SW1) is on and the second switch (SW2) are off, and a voltage computed by dividing the voltage using resistances of the third resistor (R4) and the fourth resistor (R5) when the first switch (SW1) is off and the second switch (SW2) are on.

5. A battery unit (100; 200; 600; 700) which is connectable to an external device (10), comprising:
a battery pack (110; 210; 610; 710);
a first resistor (R1) connected between a positive terminal (PV+) of the battery pack (110; 210; 610; 710) and a node (N1; N2; N3);
a second resistor (R3) arranged to be connected between the node (N1; N2; N3) and a ground terminal of the external device (10) when the battery unit (100; 200; 600; 700) is connected to the external device (10);
a third resistor (R4) and a fourth resistor (R5) arranged to be connected between the ground terminal and a negative terminal (PV-) of the battery pack (110; 210; 610; 710) when the battery unit (100; 200; 600; 700) is connected to the external device (10);
a fifth resistor (R7) connected between the node (N1; N2; N3) and the negative terminal (PV-) of the battery pack (110; 210; 610; 710); and
a processor (140; 240; 640; 740) configured to measure a voltage of the battery pack (110; 210; 610; 710) based on a voltage of a first terminal of the fifth resistor (R6, R7), and measure a first insulation resistance (R_{PI1}) formed between the positive terminal (PV+) of the battery pack (110; 210; 610; 710) and the ground terminal and a second insulation resistance (R_{PI2}) formed between the negative terminal (PV-) of the battery pack (110; 210; 610; 710) and the ground terminal based on a voltage of a first terminal of the second resistor (R2, R3) and a voltage of a contact point of the third resistor (R4) and the fourth resistor (R5),
wherein the battery unit (100; 200; 600; 700) further comprises:
a first switch (SW1) connected between the positive terminal (PV+) of the battery pack (110; 210; 610; 710) and the node (N2) on a path where the first resistor (R1) is positioned;
a sixth resistor (R2) connected between the node (N1) and the ground terminal on a path where the second resistor (R3) is positioned;
a second switch (SW2) arranged to be connected between the ground terminal and the negative terminal (PV-) of the battery pack (110; 210; 610; 710) on a path where the third resistor (R4) and the fourth resistor (R5) are positioned; and
a seventh resistor (R6) connected between the node (N2) and the negative terminal (PV-) of the battery pack (110; 210; 610; 710) on a path where the fifth resistor (R7) is positioned.

6. The battery unit (100; 200; 600; 700) of claim 5, further comprising:
a third switch connected between the node (N2) and the negative terminal (PV-) of the battery pack (110; 210; 610; 710) on a path where the fifth resistor (R7) and the seventh resistor (R6) are positioned.

7. The battery unit (100; 200; 600; 700) of claim 5, wherein:
the processor (140; 240; 640; 740) performs the following:
measuring the voltage of the battery pack (110; 210; 610; 710) based on a voltage computed by dividing the voltage using resistances of the fifth resistor (R7) and the seventh resistor (R6), when the first switch (SW1) is on and the second switch (SW2) is off; and
measuring the first insulation resistance (R_{PI1}) and the second insulation resistance (R_{PI2}) based on the voltage of the battery pack (110; 210; 610; 710), a voltage computed by dividing the voltage using resistances of the second resistor and the sixth resistor when the first switch (SW1) is on and the second switch (SW2) is off, and a voltage computed by dividing the voltage using resistances of the third resistor (R4) and the fourth resistor (R5) when the first switch (SW1) is off and the second switch (SW2) is on.

8. A battery unit (100; 200; 600; 700) which is connectable to an external device (10), comprising:
a battery pack (110; 210; 610; 710);
a first resistor (R1) connected between a positive terminal (PV+) of the battery pack (110; 210; 610; 710) and a node (N1; N2; N3);
a second resistor (R3) arranged to be connected between the node (N1; N2; N3) and a ground terminal of the external device (10) when the battery unit (100; 200; 600; 700) is connected to the external device (10);
a third resistor (R4) and a fourth resistor (R5) arranged to be connected between the ground terminal and a negative terminal (PV-) of the battery pack (110; 210; 610; 710) when the battery unit (100; 200; 600; 700) is connected to the external device (10);
a fifth resistor (R7) connected between the node (N1; N2; N3) and the negative terminal (PV-) of the battery pack (110; 210; 610; 710); and
a processor (140; 240; 640; 740) configured to measure a voltage of the battery pack (110; 210; 610; 710) based on a voltage of a first terminal of the fifth resistor (R6, R7), and measure a first insulation resistance (R_{PI1}) formed between the positive terminal (PV+) of the battery pack (110; 210; 610; 710) and the ground terminal and a second insulation resistance (R_{PI2}) formed between the negative terminal (PV-) of the battery pack (110; 210; 610; 710) and the ground terminal based on a voltage of a first terminal of the second resistor (R2, R3) and a voltage of a contact point of the third resistor (R4) and the fourth resistor (R5),
wherein the battery unit (100; 200; 600; 700) further comprises:
a first switch (SW1) arranged to be connected between the node (N3) and the ground terminal on a path where the second resistor (R3) is positioned; and
a second switch (SW2) arranged to be connected between the ground terminal and the negative terminal (PV-) of the battery pack (110; 210; 610; 710) on a path where the third resistor (R4) and the fourth resistor (R5) are positioned.

9. The battery unit (100; 200; 600; 700) of claim 8, further comprising:
a third switch (SW3) connected between the node (N3) and the negative terminal (PV-) of the battery pack (110; 210; 610; 710) on a path where the fifth resistor (R7) is positioned.

10. The battery unit (100; 200; 600; 700) of claim 8, wherein:
The processor (140; 240; 640; 740) is configured to:
measure the voltage of the battery pack (110; 210; 610; 710) based on a voltage computed by dividing the voltage using resistances of the first resistor (R1) and the fifth resistor (R7), when the first switch (SW1) and the second switch (SW2) are off; and
measure the first insulation resistance (R_{PI1}) and the second insulation resistance (R_{PI2}) based on the voltage of the battery pack (110; 210; 610; 710), a voltage computed by dividing the voltage using resistances of the first resistor (R1) and the second resistor (R3) when the first switch (SW1) is on and the second switch (SW2) is off, and a voltage computed by dividing the voltage using resistances of the third resistor (R4) and the fourth resistor (R5) when the first switch (SW1) is off and the second switch (SW2) is on.

## Patentansprüche

1. Batterieeinheit (100; 200; 600; 700), die mit einer externen Vorrichtung (10) verbindbar ist, aufweisend:
einen Batteriepack (110; 210; 610; 710);
einen ersten Widerstand (R1), der zwischen einem positiven Anschluss (PV+) des Batteriepacks (110; 210; 610; 710) und einem Knoten (N1; N2; N3) angeschlossen ist;
einen zweiten Widerstand (R3), der so angeordnet ist, dass er zwischen dem Knoten (N1; N2; N3) und einem Masseanschluss der externen Vorrichtung (10) angeschlossen ist, wenn die Batterieeinheit (100; 200; 600; 700) mit der externen Vorrichtung (10) verbunden ist;
einen dritten Widerstand (R4) und einen vierten Widerstand (R5), die so angeordnet sind, dass sie zwischen dem Masseanschluss und einem negativen Anschluss (PV-) des Batteriepacks (110; 210; 610; 710) angeschlossen sind, wenn die Batterieeinheit (100; 200; 600; 700) mit der externen Vorrichtung (10) verbunden ist;
einen fünften Widerstand (R7), der zwischen dem Knoten (N1; N2; N3) und dem negativen Anschluss (PV-) des Batteriepacks (110; 210; 610; 710) angeschlossen ist; und
einen Prozessor (140; 240; 640; 740), der so konfiguriert ist, dass er eine Spannung des Batteriepacks (110; 210; 610; 710) auf der Grundlage einer Spannung eines ersten Anschlusses des fünften Widerstands (R6, R7) misst und einen ersten Isolationswiderstand (R_{PI1}), der zwischen dem positiven Anschluss (PV+) des Batteriepacks (110; 210; 610; 710) und dem Masseanschluss gebildet wird, und einen zweiten Isolationswiderstand (R_{PI2}), der zwischen dem negativen Anschluss (PV-) des Batteriepacks (110; 210; 610; 710) und dem Masseanschluss gebildet wird, auf der Grundlage einer Spannung eines ersten Anschlusses des zweiten Widerstands (R2, R3) und einer Spannung eines Kontaktpunkts des dritten Widerstands (R4) und des vierten Widerstands (R5) misst,
wobei die Batterieeinheit (100; 200; 600; 700) ferner aufweist:
einen ersten Schalter (SW1) und einen sechsten Widerstand (R2), die so angeordnet sind, dass sie zwischen dem Knoten (N1) und dem Masseanschluss auf einem Pfad angeschlossen sind, auf dem der zweite Widerstand (R3) positioniert ist;
einen zweiten Schalter (SW2), der so angeordnet ist, dass er zwischen dem Masseanschluss und dem negativen Anschluss (PV-) des Batteriepacks (110; 210; 610; 710) auf einem Pfad angeschlossen ist, auf dem der dritte Widerstand (R4) und der vierte Widerstand (R5) positioniert sind; und
einen siebten Widerstand (R6), der zwischen dem Knoten (N1) und dem negativen Anschluss (PV-) des Batteriepacks (110; 210; 610; 710) auf einem Pfad angeschlossen ist, auf dem der fünfte Widerstand (R7) positioniert ist.

2. Batterieeinheit (100; 200; 600; 700) nach Anspruch 1, ferner aufweisend:
eine Gleichspannungsquelle (V_{DC}), die so angeordnet ist, dass sie zwischen dem Masseanschluss und dem negativen Anschluss (PV-) des Batteriepacks (110; 210; 610; 710) auf einem Pfad angeschlossen ist, auf dem der dritte Widerstand (R4) und der vierte Widerstand (R5) positioniert sind.

3. Batterieeinheit (100; 200; 600; 700) nach Anspruch 1, ferner aufweisend:
einen dritten Schalter (SW3), der zwischen dem Knoten (N1) und dem negativen Anschluss (PV-) des Batteriepacks (110; 210; 610; 710) auf einem Pfad angeschlossen ist, auf dem der fünfte Widerstand (R7) und der siebte Widerstand (R6) positioniert sind.

4. Batterieeinheit (100; 200; 600; 700) nach Anspruch 1, wobei:
der Prozessor (140; 240; 640; 740) so konfiguriert ist, dass er Folgendes durchführt:
Messen der Spannung des Batteriepacks (110; 210; 610; 710) auf der Grundlage einer Spannung, die durch Dividieren der Spannung unter Verwendung von Widerständen des fünften Widerstands (R7) und des siebten Widerstands (R6) berechnet wird, wenn der erste Schalter (SW1) und der zweite Schalter (SW2) ausgeschaltet sind; und
Messen des ersten Isolationswiderstands (R_{PI1}) und des zweiten Isolationswiderstands (R_{PI2}) auf der Grundlage der Spannung des Batteriepacks (110; 210; 610; 710), einer Spannung, die durch Dividieren der Spannung unter Verwendung von Widerständen des zweiten Widerstands und des sechsten Widerstands berechnet wird, wenn der erste Schalter (SW1) eingeschaltet ist und der zweite Schalter (SW2) ausgeschaltet ist, und einer Spannung, die durch Dividieren der Spannung unter Verwendung von Widerständen des dritten Widerstands (R4) und des vierten Widerstands (R5) berechnet wird, wenn der erste Schalter (SW1) ausgeschaltet ist und der zweite Schalter (SW2) eingeschaltet ist.

5. Batterieeinheit (100; 200; 600; 700), die mit einer externen Vorrichtung (10) verbindbar ist, aufweisend:
einen Batteriepack (110; 210; 610; 710);
einen ersten Widerstand (R1), der zwischen einem positiven Anschluss (PV+) des Batteriepacks (110; 210; 610; 710) und einem Knoten (N1; N2; N3) angeschlossen ist;
einen zweiten Widerstand (R3), der so angeordnet ist, dass er zwischen dem Knoten (N1; N2; N3) und einem Masseanschluss der externen Vorrichtung (10) angeschlossen ist, wenn die Batterieeinheit (100; 200; 600; 700) mit der externen Vorrichtung (10) verbunden ist;
einen dritten Widerstand (R4) und einen vierten Widerstand (R5), die so angeordnet sind, dass sie zwischen dem Masseanschluss und einem negativen Anschluss (PV-) des Batteriepacks (110; 210; 610; 710) angeschlossen sind, wenn die Batterieeinheit (100; 200; 600; 700) mit der externen Vorrichtung (10) verbunden ist;
einen fünften Widerstand (R7), der zwischen dem Knoten (N1; N2; N3) und dem negativen Anschluss (PV-) des Batteriepacks (110; 210; 610; 710) angeschlossen ist; und
einen Prozessor (140; 240; 640; 740), der so konfiguriert ist, dass er eine Spannung des Batteriepacks (110; 210; 610; 710) auf der Grundlage einer Spannung eines ersten Anschlusses des fünften Widerstands (R6, R7) misst und einen ersten Isolationswiderstand (R_{PI1}), der zwischen dem positiven Anschluss (PV+) des Batteriepacks (110; 210; 610; 710) und dem Masseanschluss gebildet wird, und einen zweiten Isolationswiderstand (R_{PI2}), der zwischen dem negativen Anschluss (PV-) des Batteriepacks (110; 210; 610; 710) und dem Masseanschluss gebildet wird, auf der Grundlage einer Spannung eines ersten Anschlusses des zweiten Widerstands (R2, R3) und einer Spannung eines Kontaktpunkts des dritten Widerstands (R4) und des vierten Widerstands (R5) misst,
wobei die Batterieeinheit (100; 200; 600; 700) ferner aufweist:
einen ersten Schalter (SW1), der zwischen dem positiven Anschluss (PV+) des Batteriepacks (110; 210; 610; 710) und dem Knoten (N2) auf einem Pfad angeschlossen ist, auf dem der erste Widerstand (R1) positioniert ist;
einen sechsten Widerstand (R2), der zwischen dem Knoten (N1) und dem Masseanschluss auf einem Pfad angeschlossen ist, auf dem der zweite Widerstand (R3) positioniert ist;
einen zweiten Schalter (SW2), der so angeordnet ist, dass er zwischen dem Masseanschluss und dem negativen Anschluss (PV-) des Batteriepacks (110; 210; 610; 710) auf einem Pfad angeschlossen ist, auf dem der dritte Widerstand (R4) und der vierte Widerstand (R5) positioniert sind; und
einen siebten Widerstand (R6), der zwischen dem Knoten (N2) und dem negativen Anschluss (PV-) des Batteriepacks (110; 210; 610; 710) auf einem Pfad angeschlossen ist, auf dem der fünfte Widerstand (R7) positioniert ist.

6. Batterieeinheit (100; 200; 600; 700) nach Anspruch 5, ferner aufweisend:
einen dritten Schalter, der zwischen dem Knoten (N2) und dem negativen Anschluss (PV-) des Batteriepacks (110; 210; 610; 710) auf einem Pfad angeschlossen ist, auf dem der fünfte Widerstand (R7) und der siebte Widerstand (R6) positioniert sind.

7. Batterieeinheit (100; 200; 600; 700) nach Anspruch 5, wobei:
der Prozessor (140; 240; 640; 740) Folgendes durchführt:
Messen der Spannung des Batteriepacks (110; 210; 610; 710) auf der Grundlage einer Spannung, die durch Dividieren der Spannung unter Verwendung von Widerständen des fünften Widerstands (R7) und des siebten Widerstands (R6) berechnet wird, wenn der erste Schalter (SW1) eingeschaltet ist und der zweite Schalter (SW2) ausgeschaltet ist; und
Messen des ersten Isolationswiderstands (R_{PI1}) und des zweiten Isolationswiderstands (R_{PI2}) auf der Grundlage der Spannung des Batteriepacks (110; 210; 610; 710), einer Spannung, die durch Dividieren der Spannung unter Verwendung von Widerständen des zweiten Widerstands und des sechsten Widerstands berechnet wird, wenn der erste Schalter (SW1) eingeschaltet ist und der zweite Schalter (SW2) ausgeschaltet ist, und einer Spannung, die durch Dividieren der Spannung unter Verwendung von Widerständen des dritten Widerstands (R4) und des vierten Widerstands (R5) berechnet wird, wenn der erste Schalter (SW1) ausgeschaltet ist und der zweite Schalter (SW2) eingeschaltet ist.

8. Batterieeinheit (100; 200; 600; 700), die mit einer externen Vorrichtung (10) verbindbar ist, aufweisend:
einen Batteriepack (110; 210; 610; 710);
einen ersten Widerstand (R1), der zwischen einem positiven Anschluss (PV+) des Batteriepacks (110; 210; 610; 710) und einem Knoten (N1; N2; N3) angeschlossen ist;
einen zweiten Widerstand (R3), der so angeordnet ist, dass er zwischen dem Knoten (N1; N2; N3) und einem Masseanschluss der externen Vorrichtung (10) angeschlossen ist, wenn die Batterieeinheit (100; 200; 600; 700) mit der externen Vorrichtung (10) verbunden ist;
einen dritten Widerstand (R4) und einen vierten Widerstand (R5), die so angeordnet sind, dass sie zwischen dem Masseanschluss und einem negativen Anschluss (PV-) des Batteriepacks (110; 210; 610; 710) angeschlossen sind, wenn die Batterieeinheit (100; 200; 600; 700) mit der externen Vorrichtung (10) verbunden ist;
einen fünften Widerstand (R7), der zwischen dem Knoten (N1; N2; N3) und dem negativen Anschluss (PV-) des Batteriepacks (110; 210; 610; 710) angeschlossen ist; und
einen Prozessor (140; 240; 640; 740), der so konfiguriert ist, dass er eine Spannung des Batteriepacks (110; 210; 610; 710) auf der Grundlage einer Spannung eines ersten Anschlusses des fünften Widerstands (R6, R7) misst und einen ersten Isolationswiderstand (R_{PI1}), der zwischen dem positiven Anschluss (PV+) des Batteriepacks (110; 210; 610; 710) und dem Masseanschluss gebildet wird, und einen zweiten Isolationswiderstand (R_{PI2}), der zwischen dem negativen Anschluss (PV-) des Batteriepacks (110; 210; 610; 710) und dem Masseanschluss gebildet wird, auf der Grundlage einer Spannung eines ersten Anschlusses des zweiten Widerstands (R2, R3) und einer Spannung eines Kontaktpunkts des dritten Widerstands (R4) und des vierten Widerstands (R5) misst,
wobei die Batterieeinheit (100; 200; 600; 700) ferner aufweist:
einen ersten Schalter (SW1), der so angeordnet ist, dass er zwischen dem Knoten (N3) und dem Masseanschluss auf einem Pfad angeschlossen ist, auf dem der zweite Widerstand (R3) positioniert ist; und
einen zweiten Schalter (SW2), der so angeordnet ist, dass er zwischen dem Masseanschluss und dem negativen Anschluss (PV-) des Batteriepacks (110; 210; 610; 710) auf einem Pfad angeschlossen ist, auf dem der dritte Widerstand (R4) und der vierte Widerstand (R5) positioniert sind.

9. Batterieeinheit (100; 200; 600; 700) nach Anspruch 8, ferner aufweisend:
einen dritten Schalter (SW3), der zwischen dem Knoten (N3) und dem negativen Anschluss (PV-) des Batteriepacks (110; 210; 610; 710) auf einem Pfad angeschlossen ist, auf dem der fünfte Widerstand (R7) positioniert ist.

10. Batterieeinheit (100; 200; 600; 700) nach Anspruch 8, wobei:
der Prozessor (140; 240; 640; 740) konfiguriert ist zum:
Messen der Spannung des Batteriepacks (110; 210; 610; 710) auf der Grundlage einer Spannung, die durch Dividieren der Spannung unter Verwendung von Widerständen des ersten Widerstands (R1) und des fünften Widerstands (R7) berechnet wird, wenn der erste Schalter (SW1) und der zweite Schalter (SW2) ausgeschaltet sind; und
Messen des ersten Isolationswiderstands (R_{PI1}) und des zweiten Isolationswiderstands (R_{PI2}) auf der Grundlage der Spannung des Batteriepacks (110; 210; 610; 710), einer Spannung, die durch Dividieren der Spannung unter Verwendung von Widerständen des ersten Widerstands (R1) und des zweiten Widerstands (R3) berechnet wird, wenn der erste Schalter (SW1) eingeschaltet ist und der zweite Schalter (SW2) ausgeschaltet ist, und einer Spannung, die durch Dividieren der Spannung unter Verwendung von Widerständen des dritten Widerstands (R4) und des vierten Widerstands (R5) berechnet wird, wenn der erste Schalter (SW1) ausgeschaltet ist und der zweite Schalter (SW2) eingeschaltet ist.

## Revendications

1. Unité de batterie 100; 200; 600; 700) pouvant être connectée à un dispositif externe (10) comprenant :
un bloc-batterie (110; 210; 610; 710) ;
une première résistance (R1) connectée entre une borne positive (PV+) du bloc-batterie (110; 210; 610; 710) et un nœud (N1; N2; N3) ;
une deuxième résistance (R3) agencée pour être connectée entre le nœud (N1; N2; N3) et une borne de terre du dispositif externe (10) lorsque l'unité de batterie (100; 200; 600; 700) est connectée au dispositif externe (10) ;
une troisième résistance (R4) et une quatrième résistance (R5) agencées pour être connectées entre la borne de terre et une borne négative (PV-) du bloc-batterie (110; 210; 610; 710) lorsque l'unité de batterie (100; 200; 600; 700) est connectée au dispositif externe (10);
une cinquième résistance (R7) connectée entre le nœud (N1; N2; N3) et la borne négative (PV-) du bloc-batterie (110; 210; 610; 710) ; et
un processeur (140; 240; 640; 740) configuré pour mesurer une tension du bloc-batterie (110; 210; 610; 710) d'après une tension d'une première borne de la cinquième résistance (R6, R7), et mesurer une première résistance d'isolation (R_{PI1}) formée entre la borne positive (PV+) du bloc-batterie (110; 210; 610; 710) et la borne de terre et une deuxième résistance d'isolation (R_{PI2}) formée entre la borne négative (PV-) du bloc-batterie (110; 210; 610; 710) et la borne de terre d'après une tension d'une première borne de la deuxième résistance (R2, R3) et une tension d'un point de contact de la troisième résistance (R4) et de la quatrième résistance (R5),
l'unité de batterie (100; 200; 600; 700) comprenant en outre :
un premier commutateur (SW1) et une sixième résistance (R2) agencés pour être connectés entre le nœud (N1) et la borne de terre sur un chemin où est positionnée la deuxième résistance (R3) ;
un deuxième commutateur (SW2) agencé pour être connecté entre la borne de terre et la borne négative (PV-) du bloc-batterie (110; 210; 610; 710) sur un chemin où sont positionnées la troisième résistance (R4) et la quatrième résistance (R5) ; et
une septième résistance (R6) connectée entre le nœud (N1) et la borne négative (PV-) du bloc-batterie (110; 210; 610; 710) sur un chemin où est positionnée la cinquième résistance (R7).

2. Unité de batterie (100; 200; 600; 700) selon la revendication 1, comprenant en outre :
une source de tension c.c. (V_{DC}) agencée pour être connectée entre la borne de terre et la borne négative (PV-) du bloc-batterie (110; 210; 610; 710) sur un chemin où sont positionnées la troisième résistance (R4) et la quatrième résistance (R5).

3. Unité de batterie (100; 200; 600; 700) selon la revendication 1, comprenant en outre :
un troisième commutateur (SW3) connecté entre le nœud (N1) et la borne négative (PV-) du bloc-batterie (110; 210; 610; 710) sur un chemin où sont positionnées la cinquième résistance (R7) et la septième résistance (R6).

4. Unité de batterie (100; 200; 600; 700) selon la revendication 1,
le processeur (140; 240; 640; 740) étant configuré pour effectuer ce qui suit :
mesure de la tension du bloc-batterie (110; 210; 610; 710) d'après une tension calculée en divisant la tension utilisant des résistances de la cinquième résistance (R7) et la septième résistance (R6), lorsque le premier commutateur (SW1) et le deuxième commutateur (SW2) sont désactivés ; et
mesure de la première résistance d'isolation (R_{PI1}) et de la deuxième résistance d'isolation (R_{PI2}) d'après la tension du bloc-batterie (110; 210; 610; 710), une tension calculée en divisant la tension utilisant des résistances de la deuxième résistance et de la sixième résistance lorsque le premier commutateur (SW1) est activé et le deuxième commutateur (SW2) est désactivé, et une tension calculée en divisant la tension utilisant des résistances de la troisième résistance (R4) et la quatrième résistance (R5) lorsque le premier commutateur (SW1) est désactivé et le deuxième commutateur (SW2) est activé.

5. Unité de batterie (100; 200; 600; 700) pouvant être connectée à un dispositif externe (10), comprenant :
un bloc-batterie (110; 210; 610; 710) ;
une première résistance (R1) connectée entre une borne positive (PV+) du bloc-batterie (110; 210; 610; 710) et un nœud (N1; N2; N3) ;
une deuxième résistance (R3) agencée pour être connectée entre le nœud (N1; N2; N3) et une borne de terre du dispositif externe (10) lorsque l'unité de batterie (100; 200; 600; 700) est connectée au dispositif externe (10) ;
une troisième résistance (R4) et une quatrième résistance (R5) agencées pour être connectées entre la borne de terre et une borne négative (PV-) du bloc-batterie (110; 210; 610; 710) lorsque l'unité de batterie (100; 200; 600; 700) est connectée au dispositif externe (10);
une cinquième résistance (R7) connectée entre le nœud (N1; N2; N3) et la borne négative (PV-) du bloc-batterie (110; 210; 610; 710) ; et
un processeur (140; 240; 640; 740) configuré pour mesurer une tension du bloc-batterie (110; 210; 610; 710) d'après une tension d'une première borne de la cinquième résistance (R6, R7), et mesurer une première résistance d'isolation (R_{PI1}) formée entre la borne positive (PV+) du bloc-batterie (110; 210; 610; 710) et la borne de terre et une deuxième résistance d'isolation (R_{PI2}) formée entre la borne négative (PV-) du bloc-batterie (110; 210; 610; 710) et la borne de terre d'après une tension d'une première borne de la deuxième résistance (R2, R3) et une tension d'un point de contact de la troisième résistance (R4) et de la quatrième résistance (R5),
l'unité de batterie (100; 200; 600; 700) comprenant en outre :
un premier commutateur (SW1) connecté entre la borne positive (PV+) du bloc-batterie (110; 210; 610; 710) et le nœud (N2) sur un chemin où est positionnée la première résistance (R1) ;
une sixième résistance (R2) connectée entre le nœud (N1) et la borne de terre sur un chemin où est positionnée la deuxième résistance (R3) ;
un deuxième commutateur (SW2) agencé pour être connecté entre la borne de terre et la borne négative (PV-) du bloc-batterie (110; 210; 610; 710) sur un chemin où sont positionnées la troisième résistance (R4) et la quatrième résistance (R5) ; et
une septième résistance (R6) connectée entre le nœud (N2) et la borne négative (PV-) du bloc-batterie (110; 210; 610; 710) sur un chemin où est positionnée la cinquième résistance (R7).

6. Unité de batterie (100; 200; 600; 700) selon la revendication 5, comprenant en outre :
un troisième commutateur connecté entre le nœud (N2) et la borne négative (PV-) du bloc-batterie (110; 210; 610; 710) sur un chemin où sont positionnées la cinquième résistance (R7) et la septième résistance (R6).

7. Unité de batterie (100; 200; 600; 700) selon la revendication 5,
le processeur (140; 240; 640; 740) effectuant ce qui suit :
mesure de la tension du bloc-batterie (110; 210; 610; 710) d'après une tension calculée en divisant la tension utilisant des résistances de la cinquième résistance (R7) et la septième résistance (R6), lorsque le premier commutateur (SW1) et le deuxième commutateur (SW2) sont désactivés ; et
mesure de la première résistance d'isolation (R_{PI1}) et de la deuxième résistance d'isolation (R_{PI2}) d'après la tension du bloc-batterie (110; 210; 610; 710), une tension calculée en divisant la tension utilisant des résistances de la deuxième résistance et de la sixième résistance lorsque le premier commutateur (SW1) est activé et le deuxième commutateur (SW2) est désactivé, et une tension calculée en divisant la tension utilisant des résistances de la troisième résistance (R4) et la quatrième résistance (R5) lorsque le premier commutateur (SW1) est désactivé et le deuxième commutateur (SW2) est activé.

8. Unité de batterie (100; 200; 600; 700) pouvant être connectée à un dispositif externe (10), comprenant :
un bloc-batterie (110; 210; 610; 710) ;
une première résistance (R1) connectée entre une borne positive (PV+) du bloc-batterie (110; 210; 610; 710) et un nœud (N1; N2; N3) ;
une deuxième résistance (R3) agencée pour être connectée entre le nœud (N1; N2; N3) et une borne de terre du dispositif externe (10) lorsque l'unité de batterie (100; 200; 600; 700) est connectée au dispositif externe (10) ;
une troisième résistance (R4) et une quatrième résistance (R5) agencées pour être connectées entre la borne de terre et une borne négative (PV-) du bloc-batterie (110; 210; 610; 710) lorsque l'unité de batterie (100; 200; 600; 700) est connectée au dispositif externe (10);
une cinquième résistance (R7) connectée entre le nœud (N1; N2; N3) et la borne négative (PV-) du bloc-batterie (110; 210; 610; 710) ; et
un processeur (140; 240; 640; 740) configuré pour mesurer une tension du bloc-batterie (110; 210; 610; 710) d'après une tension d'une première borne de la cinquième résistance (R6, R7), et mesurer une première résistance d'isolation (R_{PI1}) formée entre la borne positive (PV+) du bloc-batterie (110; 210; 610; 710) et la borne de terre et une deuxième résistance d'isolation (R_{PI2}) formée entre la borne négative (PV-) du bloc-batterie (110; 210; 610; 710) et la borne de terre d'après une tension d'une première borne de la deuxième résistance (R2, R3) et une tension d'un point de contact de la troisième résistance (R4) et de la quatrième résistance (R5),
l'unité de batterie (100; 200; 600; 700) comprenant en outre :
un premier commutateur (SW1) agencé pour être connecté entre le nœud (N3) et la borne de terre sur un chemin où est positionnée la deuxième résistance (R3) ; et
un deuxième commutateur (SW2) agencé pour être connecté entre la borne de terre et la borne négative (PV-) du bloc-batterie (110; 210; 610; 710) sur un chemin où sont positionnées la troisième résistance (R4) et la quatrième résistance (R5).

9. Unité de batterie (100; 200; 600; 700) selon la revendication 8, comprenant en outre :
un troisième commutateur (SW3) connecté entre le nœud (N3) et la borne négative (PV-) du bloc-batterie (110; 210; 610; 710) sur un chemin où est positionnée la cinquième résistance (R7).

10. Unité de batterie (100; 200; 600; 700) selon la revendication 8,
le processeur (140; 240; 640; 740) étant configuré pour :
mesurer la tension du bloc-batterie (110; 210; 610; 710) d'après une tension calculée en divisant la tension utilisant des résistances de la première résistance (R1) et la cinquième résistance (R7), lorsque le premier commutateur (SW1) et le deuxième commutateur (SW2) sont désactivés ; et
mesurer la première résistance d'isolation (R_{PI1}) et la deuxième résistance d'isolation (R_{PI2}) d'après la tension du bloc-batterie (110; 210; 610; 710), une tension calculée en divisant la tension utilisant des résistances de la première résistance (R1) et la deuxième résistance (R3) lorsque le premier commutateur (SW1) est activé et le deuxième commutateur (SW2) est désactivé, et une tension calculée en divisant la tension utilisant des résistances de la troisième résistance (R4) et la quatrième résistance (R5) lorsque le premier commutateur (SW1) est désactivé et le deuxième commutateur (SW2) est activé.
